# EUROPEAN PATENT APPLICATION

(11) **EP 2 099 132 A2**
(43) Date of publication of application: **09.09.2009**
(21) Application number: 09380028.2
(22) Date of filing: 20.02.2009
(51) Int. Cl.: H03K 5/1536

(54) **Device for detecting a zero-crossing of an electric alternating current**

(30) Priority: 20.02.2008 ES 200800464
(71) Applicant: Simon Tech S.L., 08013 Barcelona (ES)
(72) Inventor: Codina, Maria Cristina Moret, 08021 Barcelona (ES)
(74) Representative: Espiell Volart, Eduardo Maria

(57) **Abstract**

Device for regulating the electric feeding of a charge (1) through the alternating current, with at least some serially opposed switching elements (3) or a switching network, and a unit for controlling (2) said switching elements (3). The device comprises a comparator (5) of the saturation voltage "V_{CEsat}" of the switching elements (3), associated to an attenuation network (8) in an input terminal, insofar as in the other input terminal there is a voltage generator having the reference "V_{ref}" disposed between the collector and emitter "V_{ce}" corresponding to an "I_{ce}" current equal to zero, in order to determine the moment of null circulation and current due to said switching elements (3) through the fall of "V_{CEsat}" below "V_{ref}", determining a current zero-crossing signal to the control unit (2).

## Description

### Object of the invention

The present invention relates to a device for detecting a zero-crossing of an electric alternating current, of the type included in a device for regulating the electric feeding of a charge through alternating current.

### Background of the invention

At present there are different types of devices for regulating electric charges fed by alternating current, for example lighting devices, electric heating, engines and others. They all base their operation on the modulation capacity of the wave shape of the voltage that they feed to the charge. In this manner, they allow the energy delivered to the charge to be controlled, thereby regulating its behaviour.

The most widespread regulators are those that use a triac as a switching device. It is a three-terminal semiconductor (one for control and the other two for switching). Their main characteristics and those of interest are that their bidirectional feedback is such that it allows the passage of current there through in both directions and, once the trip signal has been sent to the control terminal (triac fusing), the device enters and remains in conduction until the current passing through it ceases or becomes null. The disconnection thereof is current-controlled.

Despite their widespread presence in the market, these regulators suffer from certain limitations, due to the operating mode of the triac device. The main ones are:
- Difficulty in regulating charges with a capacitive component, for example halogen lamps with an electronic transformer, as said electronic transformers generate additional modulation that easily defuses the triac, thereby preventing the desired behaviour.
- Generation of a high level of interferences, both conducted and radiated, with a high-frequency content. This is a consequence of the high triac switching speed, which cannot be adjusted.
- They require a radio frequency filter to block the interference generated by triac switching, said filter normally being bulky (due to the use of a coil), expensive and susceptible to generating acoustic noise due to the mechanical vibration of the coil. It is only effective within a specific frequency margin, and are susceptible to suffering from overheating and from saturation of the magnetic coil core.

The appearance of new semiconductor switching devices (such as the MOSFET field-effect transistor or IGBT insulated gate bipolar transistor, also having three terminals), propitiated the appearance of new regulating devices with different topologies and the following advantages:
- They are voltage-controlled.
- They allow their connection and disconnection to be fully controlled, which enables the regulation of capacitive charges.
- They allow the switching speed of the device to be controlled, easing the switching wave shapes and thereby reducing the interference generated.

A typical switching diagram is simple, comprising serially opposed switching elements, such as two IGBT insulated gate bipolar transistors with respective anti-parallel diodes, or a switching network, and a unit to control said switching elements when the intensity of the current that circulates through the charge is zero, determined by a zero-crossing detection device. The regulation is obtained by applying pulses of greater or lesser duration to the two IGBT insulating gate bipolar transistor control terminals, from the control unit, which determines the time that these remain in conduction. In each alternating voltage cycle, only one of the bipolar transistors will be in conduction, given that they are unidirectional devices. The current path will always cross the IGBT insulated gate bipolar transistor in conduction and the anti-parallel diode of the other IGBT bipolar transistor.

In an example of embodiment, the zero-voltage switching can be easily carried out, taking a sample of the voltage in the switching device, while the zero-current switching requires directly or indirectly measuring the current that flows through the switching device.

Thus, the use of a zero-crossing current detector for correct management is necessary.

Of the widely used multiple methods for measuring current zero-crossing, we will only mention those most used. In all of these we will assume a switching diagram with two IGBT insulated gate bipolar transistors or an equivalent switching diagram with diode bridge, MOSFET field-effect transistors or similar.

For example, current zero-crossing detectors based on shunt resistors. These devices are independent of the switching device used. Its operation is simple, consisting of alternating a known Ohmic value resistor in the path of the charge current. By measuring the terminal voltage of this resistor, we can calculate the current that circulates through it. This measurement method has the drawback of being invasive, as it requires installing a serial element in the path of the current that is the object of measurement. The shunt resistor must be adequately dimensioned, in such a manner that it allows the magnitude of the desired current to be measured, but without overlooking power dissipation that will take place in this resistor. In addition, it is very susceptible to noise, as the shunt must be sufficiently small so as not to interfere in the crossing of the current required for the charge, due to which, according to Ohm's Law, a high current variation will imply a small variation in voltage, at a level comparable to the noise. Therefore, any deviation in detection caused by the noise will lead to the point of comparison not being correct.

There are also current zero-crossing detectors, based on a current transformer. They are transformers having a primary winding coiled around the current path to be measured.

These advantages have several advantages, as they offer insulation between the power and control circuits and provide a high outgoing signal level with a certain immunity to noise, given that the circuit is activated by current.

In contrast, these devices do not allow the measurement of the continuous component of the current, are expensive and their design can be too complicated for measuring signals with wide bandwidths, for example in the megahertz range.

### Description of the invention

The electric current zero-crossing detection device that is the object of the present invention has technical peculiarities that allow a non-invasive solution in the power current circuit and a robust and completely configurable operation.

In this manner, the proposed topology is based on the use of IGBT insulated gate bipolar transistors as switching elements, for example, and leverages collector and emitter saturation voltage behaviour, although being applicable to other switching elements. This "V_{ce}" voltage is always conscious when the current is zero. Thus, the proposed solution is to monitor the current circulating between the collector and the emitter "I_{ce}" through the IGBT "V_{CEsat}", and establish the "V_{CEsat}" corresponding to null intensity, defined as voltage crossing reference "V_{ref}".

In this manner, the detection device comprises a switching element saturation voltage comparing device "V_{CEsat}", associated to an attenuation network in one of its input terminals, insofar as a voltage generator having the reference "V_{ref}" corresponding to the "I_{ce}" can be found in the other input terminal, with which current circulation is zero. Thus, the crossing-point of the two compared voltages corresponds to null intensity and determines a current zero-crossing signal to the control unit to carry out switching.

The comparator is a monolithic comparator associated to a preferably pre-established voltage level, in order to obtain a synchronisation of the zero intensity and generate the current zero-crossing signal. Therefore, depending on the type of switching element, the voltage having the reference "V_{ref}" can be different.

Additionally, the comparator has been envisaged as being an operating amplifier, a micro-controller with an internal ADC (analogue-to-digital converter), or an analogue-to-digital converter combined with a control element, such as ASIC, FPGA, CPLD, GAL or OTHER.

Likewise, the switching elements can also be constituted by different types of semiconductors, such as metal-oxide field-effect transistors (MOSFET), the aforementioned insulated gate bipolar transistors (IGBT), diode bridges or a combination of these.

As mentioned earlier, the device comprises an attenuation network that adapts the voltage obtained from the power line to that required by the comparator component itself. Said attenuation network can be comprised by a resistor network, an operating amplifier of lower amplification than the unit for the alternating electric feeding signal frequency, or an attenuator based on bipolar transistors with a lower direct transfer rate than that of the unit for the alternating electric feeding signal frequency, and its possible combinations.

Given that some electronic components can be subject to thermal stress that affects their performance and operating parameters, a temperature compensator element disposed on the comparing circuit has also been envisaged, affecting the voltage generator having the reference "V_{ref}". In this manner it adjusts to the "V_{ref}" used in the comparison from the ideal operating condition to the real operating condition.

This compensating element can be comprised of a NTC-type (negative temperature coefficient) thermal probe, a PTC-type (positive temperature coefficient) thermal probe, a digital and/or analogue monitoring circuit or a combination thereof.

As can be verified, it is a non-invasive solution, due to which interference in the charge's path is null. This allows the application of the maximum possible power to the charge without elements that can suffer from significant wear. The comparison is made with a monolithic comparator that generates a falling edge at each current zero-crossing. This falling edge is detected by the control circuit that will act on the switching elements at the time this current zero-crossing is produced. In this manner, zero current charge switching is achieved, which eliminates the brusque feedback from inductive charges.

### Description of the figures

For the purpose of complementing this description and helping to better understand the characteristics of the invention, a set of drawings in accordance with a preferred practical embodiment thereof has been included as an integral part of this specification, in which the following has been represented in an illustrative and unlimitative manner:
- Fig. 1: shows a simplified diagram of a regulating device with the electric current zero-crossing detection device;
- Fig. 2: shows a graph of the device's operation; and
- Fig. 3: shows a diagram of an electric circuit of the invention.

### Preferred embodiment of the invention

As can be observed in the foregoing figures, a circuit regulating the delivery of electric energy to an electric charge (1) comprises a control unit (2) that handles switching elements (3) on which the electric current zero-crossing detection device (4) of this invention is disposed, monitoring the electric current that crosses said switching elements (3), in such a manner that its output is connected to the control unit (2) for supplying a current zero-crossing signal upon the production of the phenomenon being sought: the saturation voltage "V_{CEsat}" crosses the comparison level "V_{ref}", due to which the current that circulates in the switching elements is null.

In this case, the switching elements (3) consist of two IGBT insulated gate bipolar transistors (31 a, 31 b), serially disposed and opposed to each other, each of these IGBT insulated gate bipolar transistors (31 a, 31 b) having an anti-parallel current circulation diode (32a, 32b) in the opposite direction.

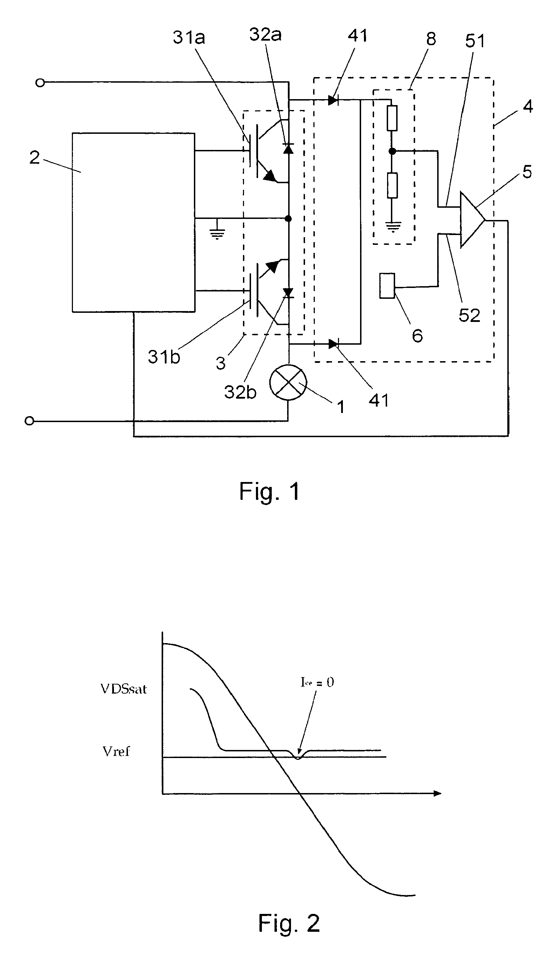

The detection device (4) is connected to the ends of the connection elements (3) by means of flow control diodes (41), which are connected through an attenuation network (8) to a non-inverting gate (51) of a monolithic comparator (5). In turn, the detection device (4) contains a referenced voltage generator (6) connected to the inverting gate (52) of the comparator (5), to establish the control function represented in Figure 1. Thus in the non-inverting gate (51), "V_{CEsat}" of the switching elements (3) is connected and the referenced voltage "V_{ref}" is connected in the inverting gate (52).

The comparator (5) exit is connected to the control unit (2) that carries out the switching according to the regulation being sought in a synchronised manner with current zero-crossing.

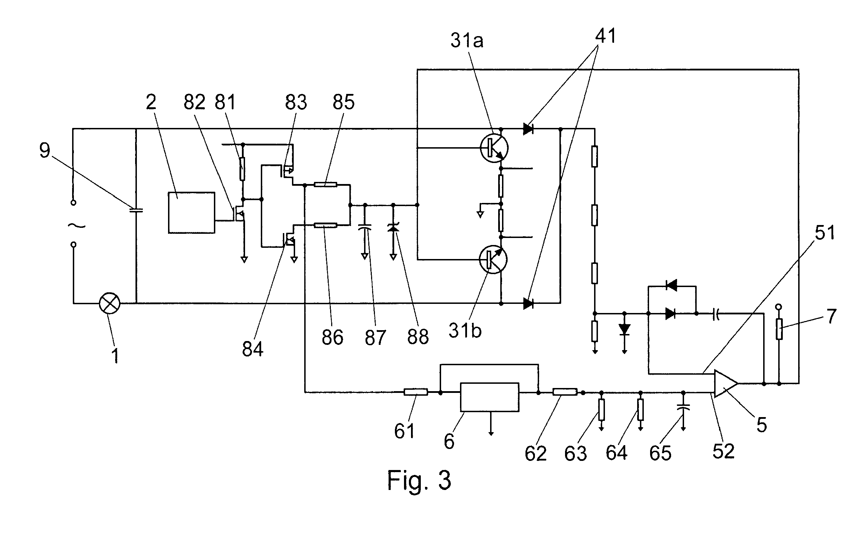

In Figure 3, voltage level "V_{ref}" of the referenced voltage generator (6) is applied as a reference in the comparator (5) in its inverting gate (52), through an adaptation network comprised of the elements (61, 62, 63, 64 and 65). Thus, the "V_{CEsat}" voltage arrives at the non-inverting gate (51) of the comparator (5) through its adaptation network (8) comprised of the elements (81, 82, 83, 84, 85, 86, 87 and 88), lowering the comparison value established in its inverting gate (52), and the output of said comparator (5) will in turn deactivate the switching elements (31 a, 31 b). Precisely in the current zero-crossing. From necessity of the specific application, the use of a pull-up type auxiliary element (7) at the comparator (5) exit. The device may comprise a condenser as a noise filter (9).

After having sufficiently described the nature of the invention, in addition to a preferred example of embodiment, we hereby state for such purposes that may arise that the materials, shape, size and arrangement of the elements described herein may be modified, provided that it does not imply an alteration of the essential characteristics of the invention that are claimed hereinafter.

## Claims

1. Device for detecting a zero-crossing of an alternating electric current, of the type included in a device for regulating the electric feeding of a charge (1) through alternating current, with at least some serially opposed switching elements (3) or a switching network, and a control unit (2) of said switching elements (3) **characterised in that** it comprises a saturation voltage "V_{CEsat}" comparator (5) of the switching elements (3), associated to an attenuation network (8) in an input terminal, insofar as there is a voltage generator (6) having the reference "V_{ref}" in the other input terminal, the value of which is equal to the saturation voltage between the collector and the emitter "V_{CEsat}" when the current "I_{ce}" is equal to zero, in order to determine the moment of null current circulation by said switching elements (3) through the fall of "V_{CEsat}" below "V_{ref}", determining a current zero-crossing signal to the control unit (2).

2. Device, according to claim 1, **characterised in that** the comparator (5) is a monolithic comparator associated to a pre-established voltage level, in order to obtain a zero-intensity synchronisation and generate a current zero-crossing signal.

3. Device, according to claim 1, **characterised in that** the comparator (5) is an operating amplifier.

4. Device, according to claim 1, **characterised in that** the comparator (5) is an analogue-to-digital converter combined with a control element.

5. Device, according to claim 1, **characterised in that** the comparator (5) is a micro-controller.

6. Device, according to claim 1, **characterised in that** the switching elements (3) consist of insulated gate bipolar transistors (31 a, 31 b) of insulated gate (IGBT).

7. Device, according to claim 1, **characterised in that** the switching elements (3) consist of metal-oxide field-effect transistors (MOSFET).

8. Device, according to any of claims 6 to 8, **characterised in that** the switching elements consist of any combination of insulated gate bipolar transistors of insulated gate, metal-oxide field-effect transistors and/or diode bridges.

9. Device, according to claim 1, **characterised in that** the attenuation network (8) consists of a resistor network.

10. Device, according to claim 1, **characterised in that** the attenuation network (8) consists of an operating amplifier of lower amplification than the unit for the alternating electric feeding signal frequency.

11. Device, according to claim 1, **characterised in that** the attenuation network (8) consists of a dissipation-based attenuator.

12. Device, according to claim 1, **characterised in that** the attenuation network (8) consists of an amplifier based on insulated gate bipolar transistors with a direct amplifier based on insulated gate bipolar transistors with a direct transfer rate lower than the unit for the alternating electric feeding signal frequency.

13. Device, according to claims 9 and 10, **characterised in that** the attenuation network (8) consists of a resistor network and an operating amplifier.

14. Device, according to claims 9 and 10, **characterised in that** the attenuation network (8) consists of a resistor network and an amplifier based on bipolar transistors.

15. Device, according to claim 1, **characterised in that** it comprises a temperature compensating element in the comparator circuit, affecting the voltage generator (6) having the reference "V_{ref}" to separate its correct generation from the variation in temperature conditions.

16. Device, according to claim 15, **characterised in that** the compensating element is a NTC thermal probe or a PTC thermal probe.

17. Device, according to claim 15, **characterised in that** the compensating element is a digital and/or analogue monitoring circuit.

18. Device, according to claims 16 and 17, **characterised in that** the compensating element is a combination of a NTC or PTC thermal probe and a digital and/or analogue monitoring circuit.
